# EUROPEAN PATENT APPLICATION

(11) **EP 3 716 310 A1**
(43) Date of publication of application: **30.09.2020**
(21) Application number: 19165629.7
(22) Date of filing: 27.03.2019
(51) Int. Cl.: H01J 37/20

(54) **SUBSTRATE POSITIONING DEVICE AND ELECTRON BEAM INSPECTION TOOL**

(71) Applicant: ASML Netherlands B.V., 5500 AH Veldhoven (NL)
(72) Inventor: HUINCK, Jeroen, Gertruda, Antonius, 5500 AH Veldhoven (NL); KOOIKER, Allard, Eelco, 5500 AH Veldhoven (NL)
(74) Representative: ASML Netherlands B.V.

(57) **Abstract**

An object positioning device, comprising:
an object support configured to support an object,
a support part configured to movably support the object support, and
at least one actuator system configured to actuate movement of the object support relative to the support part in a motion direction,
wherein the at least one actuator system comprises:
an actuator configured to apply an actuation force to the object support in a force direction wherein the force direction having a first component in the motion direction and a second component in a direction substantially perpendicular to the motion direction.

## Description

### FIELD OF THE INVENTION

The present invention relates to a substrate positioning device, and an electron beam (e-beam) inspection tool comprising such substrate positioning device.

### BACKGROUND ART

In the semiconductor processes, defects are inevitably generated. Such defects may impact device performance even up to failure. Device yield may thus be impacted, resulting in increased costs. In order to control semiconductor process yield, defect monitoring is important. One tool useful in defect monitoring is an SEM (Scanning Electron Microscope) which scans a target portion of a specimen using one or more beams of electrons.

In a known embodiment of the e-beam inspection tool, a substrate positioning device is provided to support the substrate and to position the substrate in a desired set-point position, or at least close to this desired set-point position underneath the e-beam for measurements. The substrate positioning device comprises a first part supporting the substrate, for example with an object table of the first part, and a second part that movably supports the first. In this embodiment, movement of the first part with respect to the second part is realized by placing two linear actuator systems on top of each other. The first actuator system is arranged to provide a movement in a first horizontal direction and a second actuation system, supported on the first actuation system is arranged to provide a movement in a second horizontal direction, perpendicular to the first horizontal direction.

In this substrate positioning device, each actuator system comprises permanent magnet Lorentz actuators. The first actuator system and the second actuator system are typically provided for long stroke movements of the first part with respect to the second part. The second part supports a short stroke actuator system that allows to position the object table supporting the substrate in three degrees of freedom, i.e. the vertical direction and rotations about the first and second horizontal directions. This short stroke position system enables levelling of the substrate in the focal point of the inspection beam.

The inspection E-beam can be manipulated in the first and second horizontal direction by means of a deflection unit in the inspection tool with a range of about 2 µm. This functionality may be used for fine positioning of the inspection beam relative to the substrate. The measured position error of the substrate is used as input for the deflection unit controller.

Because of this functionality, the positioning accuracy requirements of the long stroke actuation system is limited. Nevertheless the stacked long stroke actuation system based on permanent magnet Lorentz actuators has some drawbacks.

The long stroke actuation system has a position dependent compliance. This generates various vibrations due to the large excitation forces during set-point movement. Forces due to these vibrations are transported to the object table and to the frame that holds the E-beam source and determine the settling time of the system.

Furthermore, the magnetic field of the permanent magnets in the long-stroke actuator systems disturb the position of the measuring E-beam.

### SUMMARY OF THE INVENTION

It is an object of the invention to provide an alternative substrate positioning device that can be used in an e-beam inspection tool to position a substrate with respect to the e-beam. The substrate positioning device may be constructed to lack one or more of the above drawbacks of the substrate positioning device of known embodiments of the e-beam inspection tool, or at least to provide an alternative substrate positioning device.

According to a first aspect of the invention, there is provided an object positioning device, comprising:
an object support configured to support an object,
a support part configured to movably support the object support, and
at least one actuator system configured to actuate movement of the object support relative to the support part in a motion direction,
wherein the at least one actuator system comprises:
an actuator configured to apply an actuation force to the object support in a force direction wherein the force direction having a first component in the motion direction and a second component in a direction substantially perpendicular to the motion direction.

According to a second aspect of the invention, there is provided an apparatus comprising the object positioning device according to the first aspect, wherein the apparatus is a particle beam apparatus, an electron beam apparatus, an electron beam inspection apparatus, a lithographic apparatus, or a metrology apparatus.

### BRIEF DESCRIPTION OF THE DRAWINGS

The present invention will be readily understood by the following detailed description in conjunction with the accompanying drawings, wherein like reference numerals designate like structural elements, and in which:
FIG. 1A and 1B are schematic illustrations of an e-beam inspection tool according to an embodiment of the present invention;
FIG. 2 and 3 are schematic illustrations an electron optical system as can be applied in an embodiment of the present invention;
FIG. 4 schematically depicts a possible control architecture of an EBI system according to the present invention;
FIG. 5 schematically depicts a side view on an embodiment of a positioning device to be applied in the e-beam inspection tool according to the invention;
FIG. 6 schematically depicts the bottom view B-B of a part of the embodiment of Figure 5.
FIG. 7 schematically depicts an sawyer-type actuator;
FIG. 8 schematically depicts an H-shaped actuator configuration with sawyer-type actuators;
FIG. 9 schematically depicts an embodiment of a substrate positioning device;
FIG. 10 schematically depicts another embodiment of a substrate positioning device;;
FIG. 10A schematically depicts the force directions of the first actuator and the second actuator of the substrate positioning device of Figure 10;
FIG. 11 schematically depicts a top view of the substrate positioning device of FIG. 10;
FIG. 12 schematically depicts a first further embodiment of a substrate positioning device;
FIG. 13 schematically depicts a second further embodiment of a substrate positioning device;
FIG. 14 schematically depicts a third further embodiment of a substrate positioning device.
FIG. 15 schematically depicts a fourth further embodiment of a substrate positioning device.

While the invention is susceptible to various modifications and alternative forms, specific embodiments thereof are shown by way of example in the drawings and may herein be described in detail. The drawings may not be to scale. It should be understood, however, that the drawings and detailed description thereto are not intended to limit the invention to the particular form disclosed, but on the contrary, the intention is to cover all modifications, equivalents and alternatives falling within the spirit and scope of the present invention as defined by the appended claims.

### DETAILED DESCRIPTION OF EXAMPLE EMBODIMENTS

Various example embodiments of the present invention will now be described more fully with reference to the accompanying drawings in which some example embodiments of the invention are shown. In the drawings, the thicknesses of layers and regions may be exaggerated for clarity.

Detailed illustrative embodiments of the present invention are disclosed herein. However, specific structural and functional details disclosed herein are merely representative for purposes of describing example embodiments of the present invention. This invention may, however, may be embodied in many alternate forms and should not be construed as limited to only the embodiments set forth herein.

Accordingly, while example embodiments of the invention are capable of various modifications and alternative forms, embodiments thereof are shown by way of example in the drawings and will herein be described in detail. It should be understood, however, that there is no intent to limit example embodiments of the invention to the particular forms disclosed, but on the contrary, example embodiments of the invention are to cover all modifications, equivalents, and alternatives falling within the scope of the invention. Like numbers refer to like elements throughout the description of the figures.

As used herein, the term "specimen" generally refers to a wafer or any other specimen on which defects of interest (DOI) may be located. Although the terms "specimen" and "sample" are used interchangeably herein, it is to be understood that embodiments described herein with respect to a wafer may configured and/or used for any other specimen (e.g., a reticle, mask, or photomask).

As used herein, the term "wafer" generally refers to substrates formed of a semiconductor or non-semiconductor material. Examples of such a semiconductor or non-semiconductor material include, but are not limited to, monocrystalline silicon, gallium arsenide, and indium phosphide. Such substrates may be commonly found and/or processed in semiconductor fabrication facilities.

In this invention, "axial" means "in the optical axis direction of an apparatus, column or a device such as a lens", while "radial" means "in a direction perpendicular to the optical axis". Usually, the optical axis starts from the cathode and ends at specimen. The optical axis always refers to z-axis in all drawings.

The term, crossover, refers to a point where the electron beam is focused.

The term, virtual source, means the electron beam emitted from the cathode can be traced back to a "virtual" source.

The inspection tool according to the present invention relates to a charged particle source, especially to an e-beam source which can be applied to a SEM, an e-beam inspection tool, or an EBDW. The e-beam source, in this art, may also be referred to as an e-gun (Electron Gun).

With respect to the drawings, it is noted that the figures are not drawn to scale. In particular, the scale of some of the elements of the figures may be greatly exaggerated to emphasize characteristics of the elements. It is also noted that the figures are not drawn to the same scale. Elements shown in more than one figure that may be similarly configured have been indicated using the same reference numerals.

In the drawings, relative dimensions of each component and among every component may be exaggerated for clarity. Within the following description of the drawings the same or like reference numbers refer to the same or like components or entities, and only the differences with respect to the individual embodiments are described.

Accordingly, while example embodiments of the invention are capable of various modifications and alternative forms, embodiments thereof are shown by way of example in the drawings and will herein be described in detail. It should be understood, however, that there is no intent to limit example embodiments of the invention to the particular forms disclosed, but on the contrary, example embodiments of the invention are to cover all modifications, equivalents, and alternatives falling within the scope of the invention.

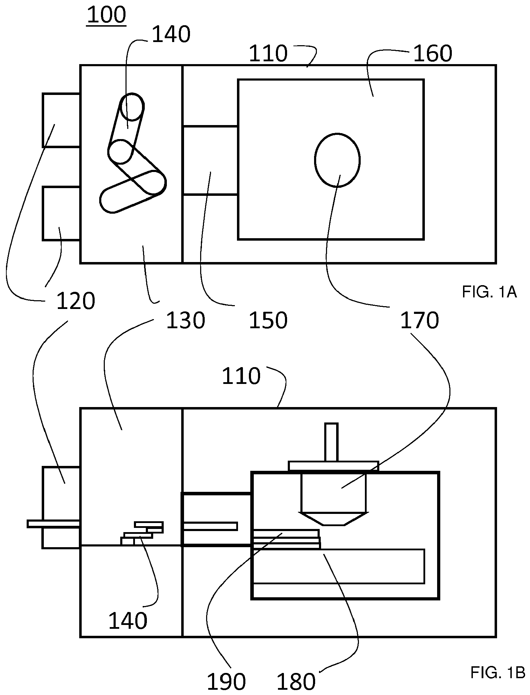

Figures 1A and 1B schematically depict a top view and a cross-sectional view of an electron beam (e-beam) inspection (EBI) system 100 according to an embodiment of the present invention. The embodiment as shown comprises an enclosure 110, a pair of load ports 120 serving as an interface to receive objects to be examined and to output objects that have been examined. The embodiment as shown further comprises an object transfer system, referred as an EFEM, equipment front end module 130, that is configured to handle and/or transport the objects to and from the load ports. In the embodiment as shown, the EFEM 130 comprises a handler robot 140 configured to transport objects between the load ports and a load lock 150 of the EBI system 100. The load lock 150 is an interface between atmospheric conditions occurring outside the enclosure 110 and in the EFEM and the vacuum conditions occurring in a vacuum chamber 160 of the EBI system 100. In the embodiment as shown, the vacuum chamber 160 comprises an electron optics system 170 configured to project an e-beam onto an object to be inspected, e.g. a semiconductor substrate or wafer. The EBI system 100 further comprises a positioning device 180 that is configured to displace the object 190 relative to the e-beam generated by the electron optics system 170.

In an embodiment, the positioning device may comprise a cascaded arrangement of multiple positioners such an XY-stage for positioning the object in a substantially horizontal plane, and a Z-stage for positioning the object in the vertical direction.

In an embodiment, the positioning device may comprise a combination of a coarse positioner, configured to provide a coarse positioning of the object over comparatively large distances and a fine positioner, configured to provide a fine positioning of the object over comparatively small distances.

In an embodiment, the positioning device 180 further comprises an object table for holding the object during the inspection process performed by the EBI system 100. In such embodiment, the object 190 may be clamped onto the object table by means of a clamp such as an electrostatic clamp. Such a clamp may be integrated in the object table.

In accordance with the present invention, the positioning device 180 comprises a first positioner for positioning the object table and a second positioner for positioning the first positioner and the object table. In addition, the positioning device 180 as applied in the e-beam inspection tool 100 according to the present invention comprises a heating device that is configured to generate a heat load in the object table.

The positioning device 180 and heating device as applied in the present invention will be discussed in more detail below.

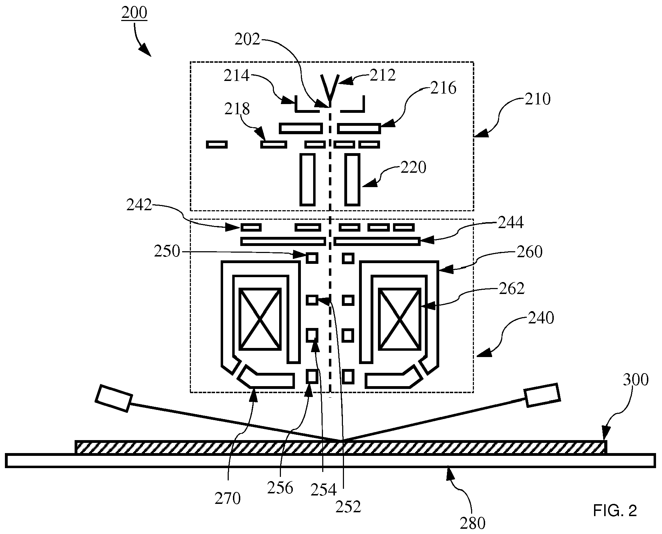

Figure 2 schematically depict an embodiment of an electron optics system 200 as can be applied in e-beam inspection tool or system according to the present invention. The electron optics system 200 comprises an e-beam source, referred to as the electron gun 210 and an imaging system 240.

The electron gun 210 comprises an electron source 212, suppressor 214, an anode 216, a set of apertures 218, and a condenser 220. The electron source 212 can be a Schottky emitter. More specifically, the electron source 212 includes a ceramic substrate, two electrodes, a tungsten filament, and a tungsten pin. The two electrodes are fixed in parallel to the ceramic substrate, and the other sides of the two electrodes are respectively connected to two ends of the tungsten filament. The tungsten is slightly bended to form a tip for placing the tungsten pin. Next, a ZrO2 is coated on the surface of the tungsten pin, and is heated to 1300°C so as to be melted and cover the tungsten pin but uncover the pinpoint of the tungsten pin. The melted ZrO2 can make the work function of the tungsten lowered and decrease the energy barrier of the emitted electron, and thus the electron beam 202 is emitted efficiently. Then, by applying negative electricity to the suppressor 214, the electron beam 202 is suppressed. Accordingly, the electron beam having the large spread angle is suppressed to the primary electron beam 202, and thus the brightness of the electron beam 202 is enhanced. By the positive charge of the anode 216, the electron beam 202 can be extracted, and then the Coulomb's compulsive force of the electron beam 202 may be controlled by using the tunable aperture 218 which has different aperture sizes for eliminating the unnecessary electron beam outside of the aperture. In order to condense the electron beam 202, the condenser 220 is applied to the electron beam 202, which also provides magnification. The condenser 220 shown in the figure 2 may e.g. be an electrostatic lens which can condense the electron beam 202. On the other hand, the condenser 220 can be also a magnetic lens.

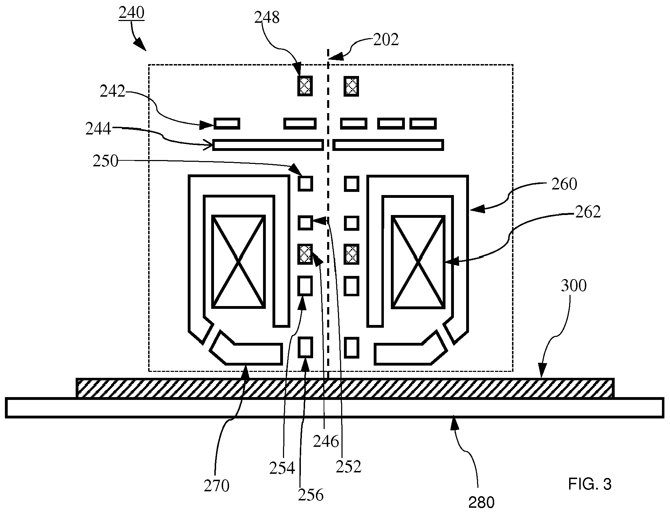

The imaging system 240 as shown in Figure 3 comprises a blanker 248, a set of apertures 242, a detector 244, four sets of deflectors 250, 252, 254, and 256, a pair of coils 262, a yoke 260, a filter 246, and an electrode 270. The electrode 270 is used to retard and deflect the electron beam 202, and further has electrostatic lens function due to the combination of upper pole piece and sample 300. Besides, the coil 262 and the yoke 260 are configured to the magnetic objective lens.

The electron beam 202, described above, is generated by heating the electron pin and applying the electric field to anode 216, so that, in order to stabilize the electron beam 202, there must be a long time for heating the electron pin. For a user end, it is surely time consuming and inconvenient. Hence, the blanker 248 is applied to the condensed electron beam 202 for temporally deflecting the electron beam 202 away from the sample rather than turning off it.

The deflectors 250 and 256 are applied to scan the electron beam 202 to a large field of view, and the deflectors 252 and 254 are used for scanning the electron beam 202 to a small field of view. All the deflectors 250, 252, 254, and 256 can control the scanning direction of the electron beam 202. The deflectors 250, 252, 254, and 256 can be electrostatic deflectors or magnetic deflectors. The opening of the yoke 260 is faced to the sample 300, which immerses the magnetic field into the sample 300. On the other hand, the electrode 270 is placed beneath the opening of the yoke 260, and therefore the sample 300 will not be damaged. In order to correct the chromatic aberration of the electron beam 202, the retarder 270, the sample 300, and the upper pole piece form a lens to eliminate the chromatic aberration of the electron beam 202.

Besides, when the electron beam 202 bombards into the sample 300, a secondary electron will be emanated from the surface of the sample 300. Next the secondary electron is directed to the detector 244 by the filter 246.

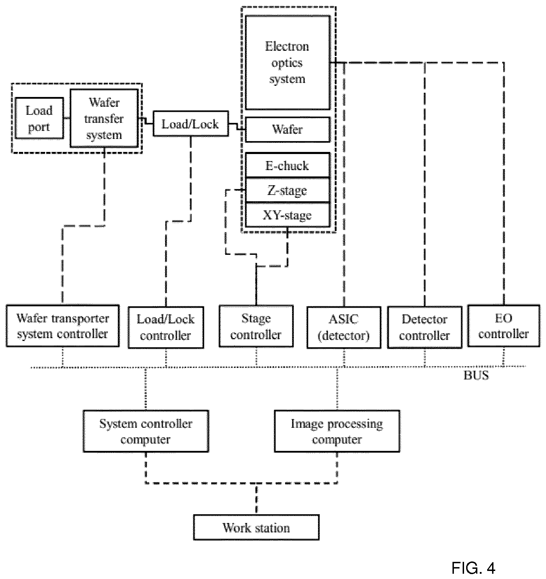

Figure 4 schematically depicts a possible control architecture of an EBI system according to the present invention. As indicated in Figure 1, the EBI system comprises a load lock, a wafer transfer system, a load/lock, an electron optics system and a positioning device, e.g. including a z-stage and an x-y stage. As illustrated, these various components of the EBI system may be equipped with respective controllers, i.e., a wafer transporter system controller connected to the wafer transfer system, a load/lock controller, an electron optics controller, a detector controller, a stage controller. These controllers may e.g. be communicatively connected to a system controller computer and an image processing computer, e.g. via a communication bus. In the embodiment as shown, the system controller computer and the image processing computer may be connected to a workstation.

The load port loads a wafer to the wafer transfer system, such as EREM 130, and the wafer transfer system controller controls the wafer transfer to transfer the wafer to the load/lock, such as load lock 150. The load/lock controller controls the load/lock to the chamber, such that an object that is to be examiner, e.g. a wafer can be fixed on a clamp, e.g. an electrostatic clamp, also referred to as an e-chuck. The positioning device, e.g. the z-stage and the x-y stage, enable the wafer to move by the stage controller. In an embodiment, a height of the z-stage may e.g. be adjusted using a piezo component such as a piezo actuator. The electron optic controller may control all the conditions of the electron optics system, and the detector controller may receive and convert the electric signals from the electron optic system to image signals. The system controller computer is to send the commands to the corresponding controller. After receiving the image signals, the image processing computer may process the image signals to identify defects.

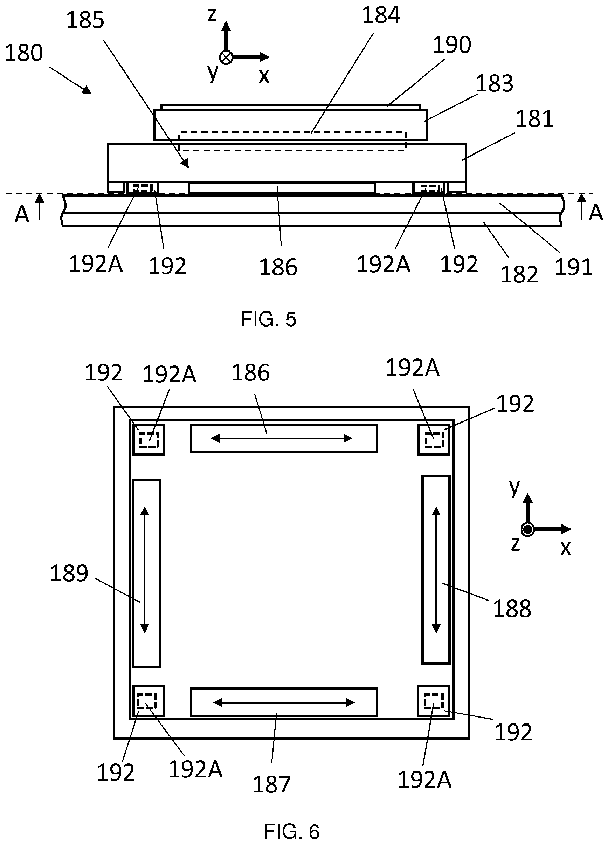

Figure 5 schematically depicts an embodiment of a substrate positioning device 180 for an e-beam inspection tool 1 according to an embodiment of the present invention. The substrate positioning device 180 comprises a first part 181 and a second part 182 which is movable, at least in the horizontal plane, with respect to the first part 181. The first part 181 comprises an object table 183 to support the object 190, in particular a substrate, and a short stroke actuator system 184 for fine positioning of the object table 183.

A planar actuator system 185 is provided to actuate movement of the first part 181 with respect to the second part 182 in the horizontal plane, i.e. movement in the perpendicular horizontal directions (x, y) and rotation about the vertical axis (Rz).

The planar actuation system 185 comprises a number of actuators to actuate the movement of the first part 181 with respect to the second part 182.

Figure 6 shows a bottom view of the first part 181 from the line A-A (indicated in Figure 5). Figure 6 shows a first forcer 186 of a first actuator and a second forcer 187 of a second actuator to actuate the first part 181 in the horizontal x-direction, and a third forcer 188 of a third actuator and a fourth forcer 189 of a fourth actuator to actuate the first part 181 in the horizontal y-direction.

All four forcers 186, 187, 188 and 189 cooperate with a common stator 191 of the second part 182 in order to exert a force in the respective horizontal direction.

To support the first part 181 in the vertical direction, i.e. z-direction, four passive bearings 192 are provided. These passive bearings 192 do not actively control the position of the first part 181 with respect to the second part 182, but provide vertical support to hold the first part 181. This means that when the actuator system 185 fails or is shut down, the first part 181 remains to be supported by the passive bearings 192 and does not fall down on the second part 182. As a result, no separate system to prevent or guide falling down of the first part 181 has to be provided.

In an embodiment, the passive bearings 192 are mechanical support feet that provide support by mechanical contact between the passive bearings 192 and the second part 182. Wear of the mechanical support feet due to sliding of the mechanical support feet over the surface of the second part 182 may be minimized by selecting proper material combination of the mechanical support feet and the top surface of the common stator 191, and lubrication of the mechanical contact area between the mechanical support feet and the top surface of the common stator 191.

The common stator 191 may for example be an aluminum block or plate having a horizontal top surface which may act as a bearing surface for the passive bearings 192 and as an actuator interface for each of the forcers 186, 187, 188 and 189.

A preload of the passive bearings 192 may be required to ensure that the first part 181 does not slide with respect to the second part 182 without being actuated for such movement. This preload may be realized with gravity load and additional preload created by a force actuation system 192A arranged to exert a preload force between the first part and the second part in the vertical direction. The force actuation system 192A may for example comprise electro-magnets in the mechanical support feet that exert a pulling force the common stator 191 or a body of the second part 182 beneath the common stator 191.

In an alternative embodiment, the passive bearings 192 may be gas bearings, for example air bearings, to provide a high vertical stiffness and damping without direct mechanical contact between the passive bearings 192 and the second part 182. The required preload may for example be obtained by creating a vacuum to pull the first part 181 on the top surface of the stator 191.

The mechanical support feet have the advantage that they also can be used in a conditioned space with reduced pressure, i.e. a vacuum space. In such space air bearings cannot be applied. The advantage of the air bearings is that there is no direct mechanical contact between the passive bearings 192 and the common stator 191 preventing wear of the passive bearings 192.

The preload may also be realized by any other force actuation system 192A to exert a preload force between the first part and the second part in the vertical direction. The force actuation system 192A may be provided in or on the first part 181, in particular the passive bearings 192 and/or the second part 182, in particular the stator 191.

In an embodiment, the forcers 186, 187, 188 and 189 of the actuators are induction-type motors. In an induction-type motor, the forcers 186, 187, 188 and 189 are arranged to generate a magnetic field that moves over the common electrical stator 191 where eddy current forces are generated. These stator eddy currents in combination with the magnetic field generated by the forcers 186, 187, 188 and 189 generate a relative force between the forcers 186, 187, 188 and 189 and the stator 191. In the planar configuration of the planar actuator system 185, the force direction of each of the forcers 186, 187, 188 and 189 is only determined by the orientation of the respective forcer 186, 187, 188, 189. In the embodiment of Figure 5, the first forcer 186 and the second forcer 187 will generate a force in the horizontal x-direction, while the third forcer 188 and the fourth forcer 189 will generate a force in the horizontal y-direction. It will be clear that a rotation of the first part 181 about the vertical axis Rz can be created by actuation of one or more of the four actuators.

The actuated force in an induction-type motor depends on the relative speed between the magnetic field generated by the respective forcer 186, 187, 188, 189 and the stator 191, and the current of the respective forcer 186, 187, 188, 189. The stator 191 to be used in combination with the induction-type motors may be continuous, i.e. without teeth or other patterns, and as a result has no position dependent forces.

This positioning device 180 has a low mechanical complexity, and can easily and reliably be controlled. Furthermore, there is no risk of falling down of the first part 181 in case the planar actuation system 185 fails, since the passive bearings 192 prevent falling down of the first part 181.

Another advantage of this positioning device 180 is that the planar actuator system 185 is free of permanent magnets, i.e. the induction-type motors do not use permanent magnets as used in Lorentz type motors. This also allows another control method to advantageously control the position of the object table 183. In this control method, the forcers 186, 187, 188 and 189 are actuated to position the object table 183 in a desired set-point position (x, y, Rz), or at least close to that position, i.e. within the control range of the short stroke actuator system 184 and/or a deflection unit of the e-beam source. Once the object table 183 is arranged in this position, the forcer current of all forcers 186, 187, 188 and 189 may be switched off. As a result, there is no longer any magnetic field generated by one of the forcers 186, 187, 188 and 189.

The high horizontal and vertical stiffness of the passive bearings 192 guarantees that the position of the first part 181 is stable and properly damped, which results in a low settling time. Since there is no permanent magnet in the planar actuator system 185, the planar actuator system 185 does not create any magnetic field, once the forcers 186, 187, 188 and 189 are switched off, that can negatively influence the measurements with the e-beam of the e-beam source.

Furthermore, any small positioning error in the position of the object table 183 can be corrected by the short stroke actuator system 184, or, as an alternative or in addition, such positioning error may be compensated by a deflection unit of the e-beam source.

It is remarked that, since in this control method, during measurements with the e-beam, the first part 181 will be supported by the passive bearings 192 without any active actuation forces being exerted by the planar actuator system 184, dynamical disturbance effects cannot be compensated.

During measurements the stator 191 may be mechanically fixed to first part 181. Therefore, possible vibrations of the stator 191 during measurements should be minimized. This can for example be realized by a compliant support of the stator 191 in combination with a frame motion compensation system between a support, for example a support floor, and the stator 191, or, as an alternative, a relatively stiff connection between the stator 191 and the e-beam electron optics system 200 may be provided. The compliant support of the stator 191 in combination with a frame motion compensation system enables dynamic isolation of the electron optics system 200 against movements of the first part 181. Therefore it is desirable that isolation of any dynamical disturbance should be realized with a metroframe which is isolated from external dynamical disturbances.

Another advantage of the induction-type motors is that the forcers 186, 187, 188 and 189 do not require commutation position input. This means that there is no requirement to provide an accurate commutation measurement system and commutation alignment during initialization of the positioning device 180.

To avoid that the common stator 191 will become overheated, a cooling device may be provided in the stator 191.

In an alternative embodiment of the planar actuation system 185, the forcers 186, 187, 188 and 189 of the actuators of the planar actuation system 185 may be reluctance-type motors. The advantage of reluctance-type motors, similar to the induction-type motors, is that they do not comprise permanent magnets. As a result, they will only generate a magnetic field when activated. This means that in a position control method as described above, in which the first part 181 is brought into or close by a desired position and then no longer activated but supported on the passive bearings 192, the planar actuation system no longer generates a magnetic field that can negatively influence the e-beam of the e-beam source during e-beam measurements.

A reluctance-type motor, in particular its forcer, may be of relatively light and compact design, which is advantageous for integrating the forcers into the first part 181 of the positioning device 180.

A stator 191 of a reluctance motor may require cooling. A cooling device may for this reason be provided in the stator 191. However, no active cooling may be required in the forcers 186, 187, 188 and 189, and as a result no cooling connection has to be made to the movable first part 181, such as a cooling water hose.

It is remarked that reluctance-type motors may also be applied in the short stroke actuator system 184 to position the object table 183 with high accuracy with respect to the e-beam.

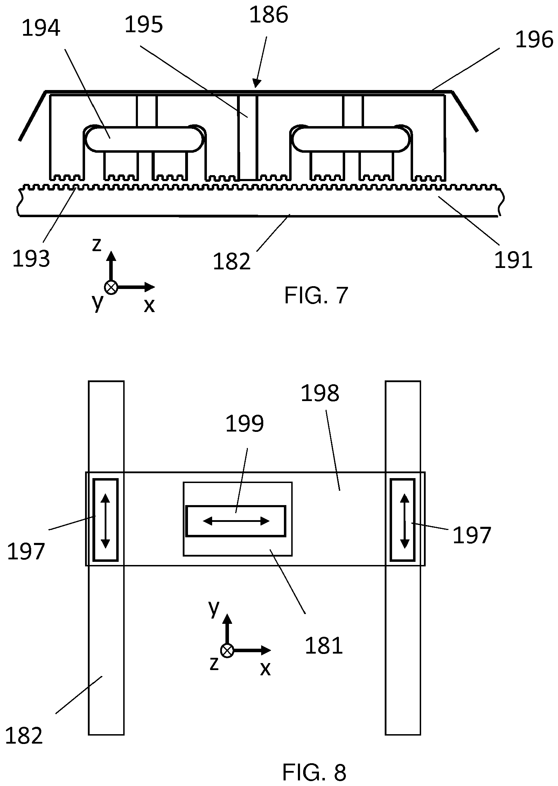

In yet an alternative embodiment of the planar actuation system 185, the forcers 186, 187, 188 and 189 of the actuators of the planar actuation system 185 may be sawyer-type motors. An example of such sawyer-type motor (forcer 186) is shown in Figure 7. The other forcers 187, 188, 189 may be constructed correspondingly. It is remarked that the sawyer-type motor may also be constructed with other, alternative coil configurations.

The stator 191 comprises an array of ferromagnetic poles 193. The forcer 186 comprises a two-phase coil system 194 and a permanent magnet 195. An advantage of such construction is that the permanent magnet 195 is arranged in the forcer 186 at a lower area of the planar actuation system 185. The permanent magnet 195 can therefor effectively magnetically be shielded by a shielding device 196 to prevent that the magnetic field of the permanent magnet 195 negatively influences the e-beam of the e-source in a e-beam inspection tool.

When applying a block-shaped current to the two-phase coil system 194, a step will be made by the forcer 186 with respect to the stator 191 in the force direction of the forcer 186. Such step has a distance of lambda/4, where lambda equals the stator tooth pitch. By continuously applying the block-shaped current to the two-phase coil system 194, the forcer 186 can be moved along the stator 191 with these steps.

When using a block-shaped current to apply to the two-phase coil system 194, the forcer cannot be positioned in an intermediate position between the step positions. However, when applying sinusoidal currents to the two-phase coil system 194, a controllable force can be provided by the forcer 186 that allows positioning of the forcer in any desired intermediate position.

The planar actuation system 185 based on forcers of the sawyer-type, provides a suitable planar configuration in which the forcers 186, 187, 188, 189 allow movement over a longer distance. At the same time, the forcers 186, 187, 188, 189 can be provided in a compact and light design, whereby the permanent magnet 195 in each of the forcers 186, 187, 188, 189 can be effectively magnetically shielded by a shielding device 196 that prevents that the e-beam is negatively influenced by the magnetic field of the permanent magnet 195.

The forcers based on the sawyer-type may also be applied in other drive configurations than the planar configuration of Figure 5. Figure 8 shows a H-configuration with sawyer-type motors. In this H-configuration two sawyer-type motors 197 are provided to move a cross beam 198 in y-direction with respect to the second part 182 of the positioning device. On the cross beam 198 a further sawyer-type motor 199 is provided to move the first part 181 in the x-direction.

By controlling the two sawyer-type motors 197 for movement in the y-direction and the further sawyer-type motor 199 for movement in the x-direction the first part 181, in particular an object table supported thereon, may be arranged in any desirable position in the horizontal plane.

Also in this H-configuration, only permanent magnets are provided in the two sawyer-type motors 197 and the further sawyer-type motor 199. These permanent magnets can effectively be shielded by a shielding device 196, as shown in Figure 7.

It is remarked that, in alternative embodiments, the permanent magnet 195 of the Sawyer-type forcers may be replaced by a direct current (DC) coil. In such embodiment, all the magnetic field sources of the forcers can be switched off during measurement, thus possibly eliminating the requirement of magnetic shielding as applied in the sawyer-type forcers shown in Figures 7 and 8. Such motor may be referred to as a sawyer type motor having a direct current (DC) coil, or as an alternative, as a parallel flux switching machine or a Vernier hybrid machine.

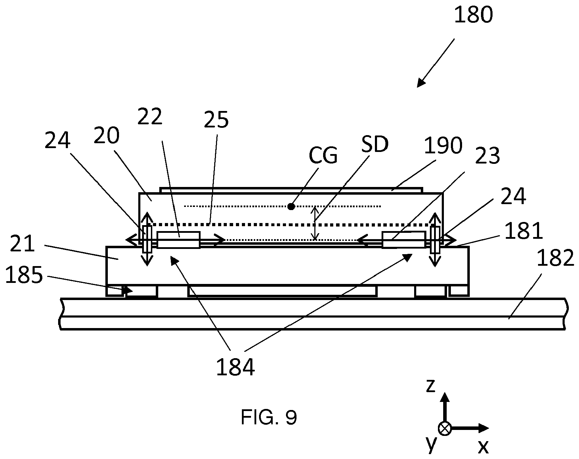

Figure 9 shows an embodiment of a substrate positioning device 180. The substrate positioning device 180 comprises a first part 181 and a second part 182. The first part 181 is movable, at least in the horizontal plane, with respect to the second part 182.

A planar actuator system 185 is provided to actuate movement of the first part 181 with respect to the second part 182 in at least the horizontal plane, i.e. movement in the perpendicular horizontal directions (x, y) and rotation about the vertical axis (Rz). The planar actuator system 185 may have any suitable configuration as described with respect to the embodiments of Figures 5-8. Any other actuator system to move the first part 181 with respect to the second part 182 may also be used. In an embodiment, the actuator system 185 is configured to move the first part 181 with respect to the second part 182 in six degrees of freedom.

The first part 181 comprises an object support 20 configured to support an object, for example a substrate 190. The object support 20 comprises a center of gravity CG. The object support 20 may for example comprise a mirror block or an encoder block and a substrate table to support the substrate 190. The first part 181 further comprises a support part 21, that movably supports the object support 20. The object support 20 is at least movable with respect to the support part 21 in a first motion direction, the x-direction. In practice, the object support 20 may be movable in multiple degrees of freedom with respect to the support part 21, for example three or six degrees of freedom. In an embodiment, the center of gravity CG is the center of gravity of the object support 20. In another embodiment, the center of gravity CG may be the center of gravity of the combination of the object support 20 and the object held by the object support 20.

The substrate positioning device 180 comprises a short stroke actuator system 184 for fine positioning of the object support 20 with respect to the support part 21. The short stroke actuator system 184 comprises a first actuator 22 and a second actuator 23 arranged to exert an actuation force in the first motion direction in order to displace the object support 20 with respect to the support part 21 in the first motion direction (x-direction).

The short stroke actuator system 184 further comprises four further actuators 24 to exert a further actuation force in a vertical direction, i.e. the z-direction.

The first actuator 22 and the second actuator 23 are spaced in a spacing direction from the center of gravity CG of the object support 20. This spacing has a spacing distance SD in a vertical spacing direction, z-direction, perpendicular to the first motion direction. In other words the center of gravity CG of the object support 20 is located in a first horizontal x-y plane and the first actuator 22 and the second actuator 23 are located in a second horizontal x-y plane, wherein the first horizontal plane and the second horizontal plane are spaced in the vertical direction with the spacing distance SD.

Such spacing in the vertical direction between the center of gravity CG of the object support 20 and the plane in which the first actuator 22 and the second actuator 23 are arranged may have the drawback that this distance may result in moments in the object support 20 as a result of exerting an actuation force with the first actuator 22 and/or the second actuator 23. This may cause an undesired rotation of the object support 20. These moments need therefore to be counteracted with the further actuators 24 that act in the vertical direction.

With increasing spacing distance SD, the forces to be exerted by the further actuators 24 will generally also increase to compensate the moments created by the first actuator 22 and/or the second actuator 23. Larger forces may also require larger further actuators 24, that will typically generate more heat and therefore require increase cooling capacity. More heat may also lead to more thermomechanical and thermal disturbances in the substrate 190 supported by the object support 20.

Another drawback of the spacing distance SD between the center of gravity of the object support 20 and the plane in which the first actuator 22 and the second actuator 23 are arranged is that the moments resulting from this spacing may lead to bending of the object support 20, for example deformation of a mirror block or encoder block, and/or internal chuck deformation (ICD). Moreover, in case visco-elastic material is applied in the short stroke actuator system 184, e.g. in an actuator suspension for vibration damping purpose, the larger forces may lead to more visco-elastic behavior, for example creep behavior, and therefore longer settling time and/or a larger deformation error.

In view of the above, it is desirable that the spacing distance SD is small. However, in some applications a minimum spacing distance SD is required. For example in a substrate positioning device 180 of an e-beam apparatus, for example an e-beam inspection tool, a magnetic shield 25 is required between the actuators 22, 23, 24 and the substrate 190, to avoid disturbances of the electron beam to be irradiated onto the substrate 190 by the magnetic stray fields of the actuators 22, 23, 24. The magnetic shield 25 may be located between the substrate 190 and the actuators 22, 23, 24 to shield the magnetic stray fields of the actuators 22,23, 24. This results in a relatively large spacing distance SD between the center of gravity CG of the object support 20 and the first actuator 22 and the second actuator 23 that exert actuation forces in the first motion direction.

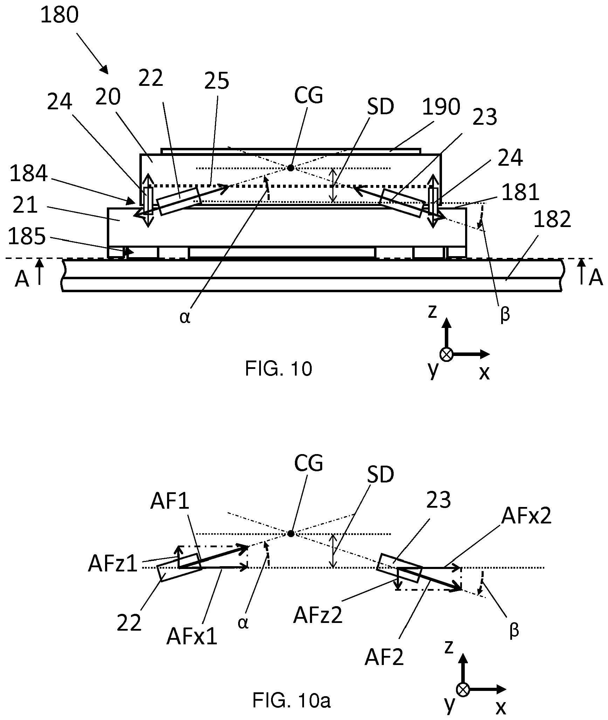

Figure 10 shows another embodiment of a substrate positioning device 180. The substrate positioning device 180 comprises a first actuator 22 and a second actuator 23 in a tilted arrangement. The first actuator 22 is arranged to exert a first actuation force between the object support 20 and the support part 21 in a first force direction. The second actuator 23 is arranged to exert a second actuation force between the object support 20 and the support part 21 in a second force direction. The first force direction of the first actuator 22 and the second force direction of the second actuator 23 each comprise a first (non-zero) component in the spacing direction, in this embodiment z-direction, and a second (non-zero) component in the first motion direction, in this embodiment x-direction, as shown in more detail in Figure 10A.

Figure 10A shows the force directions of the first actuator 22 and the second actuator 23 with respect to the center of gravity CG in more detail. In Figure 10A, the first actuator 22 is arranged to exert a first actuation force AF1 in the first force direction and the second actuator 23 is arranged to exert a second actuation force AF2 in the second force direction in order to move the object support 20 with respect to the support part 21 in the positive direction of the first motion direction. The first actuation force AF1 of the first actuator 22 comprises a first spacing direction component AFz1 in the spacing direction SD, e.g. the z-direction, and a first motion direction component AFx1 in the first motion direction, e.g. x direction. Correspondingly, the second actuation force AF2 of the second actuator 23 comprises a second spacing direction component AFz2 in the spacing direction SD, e.g. the z-direction, and a second motion direction component AFx2 in the first motion direction, e.g. x direction. The first spacing direction component AFz1 and the second spacing direction component AFz2 are opposite to each other, while the first motion direction component AFx1 and the second motion direction component AFx2 are parallel in the same direction.

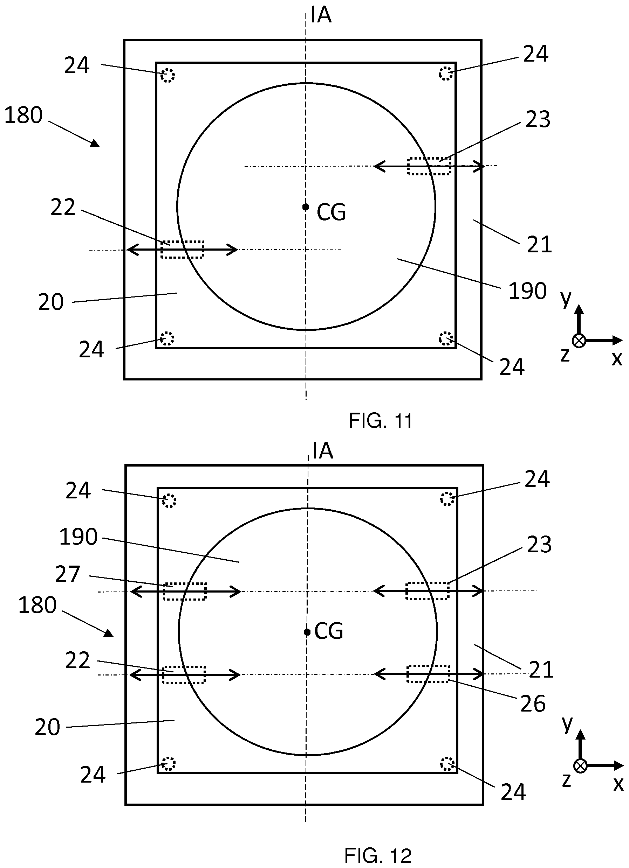

Figure 11 shows a top view of the substrate positioning device 180 of Figure 10 indicating locations of respective actuators 22, 23, 24. It can be seen that the first force direction of the first actuator 22 and the second force direction of the second actuator 23 do not have a component in the y-direction. In Figure 11, an imaginary axis IA is drawn which runs in y-direction through the center of gravity CG of the object support 20. This y-direction is perpendicular to the first motion direction and the spacing direction.

The first force direction of the first actuator 22 and the second force direction of the second actuator 23 are both directed to the imaginary axis IA. Since the respective actuation force of each of the first actuator 22 and the second actuator 23 is directed to the imaginary axis IA, the moments about the imaginary axis IA resulting from the spacing distance SD are substantially reduced. At the same time, the spacing distance SD between the horizontal plane in which the first actuator 22 and the second actuator 23 are arranged and the horizontal plane in which the center of gravity CG of the object support 20 is located is maintained, to accommodate the arrangement of the magnetic shield 25 at an effective location.

Due to the substantial reduction of the moments about the imaginary axis IA introduced into the object support 20 due to exerting actuation forces on the object support 20 with the tilted first actuator 22 and the tilted second actuator 23, the compensation forces required by the further actuators 24 to compensate for the moments about the imaginary axis IA are also substantially reduced. This means that the further actuators 24 may be constructed to be less powerful and less complex. Also, since the forces required by the further actuators 24 are smaller, there will be less heat dissipation by the further actuators 24. Less heat dissipation of the further actuators 24 also results in less stringent requirements for the design of the object support with respect to thermomechanical and thermal disturbances of the object support 20 and/or the cooling capacity required to compensate the heat dissipation.

Further, since the moments about the imaginary axis IA introduced into the object support 20 are smaller there will be less deformation/bending of the object support 20 upon actuation of the object support 20 by the tilted first actuator 22 and the tilted second actuator 23.

As shown in Figure 10A, the sum of the first tilt angle α of the first actuator 22 with respect to the positive x-direction and the second tilt angle β of the second actuator 23 with respect to the positive x-direction may be 0 degrees; i.e. α + β = 0 degrees. In Figure 10A, the first actuator 22 exerts a first actuation force AF1 in the positive x-direction (to the right in Figure 10A) and the second actuator 23 exerts a second actuation force AF2 in the positive x-direction, whereby the magnitudes of the first actuation force AF1 and the second actuation force AF2 are the same. Since the sum of the first tilt angle α and the second tilt angle β with respect to the positive x-direction is 0 degrees, the first spacing direction component AFz1 and the second spacing direction component AFz2 will have the same magnitude, but are directed in opposite directions (positive vs. negative z-direction), while the first motion direction component AFx1 and the second motion direction component AFx2 will have the same magnitude and the same direction (positive x-direction). The first spacing direction component AFz1 and the second spacing direction component AFz2 will therefore compensate each other, when the object support 20 is actuated with the first actuation force AF1 and the second actuation force AF2 in the first motion direction.

As can be seen in Figure 11, a first point of intersection of the first force direction of the first actuator 22 and the imaginary axis IA is located on a first imaginary axis part of the imaginary axis IA, the first imaginary axis part extending from the center of gravity CG in a first imaginary axis direction, e.g. negative y-direction, and a second point of intersection of the second force direction of the second actuator 23 and the imaginary axis IA is located on a second imaginary axis part of the imaginary axis IA, the second imaginary axis part extending from the center of gravity in a second imaginary axis direction, e.g. positive y-direction. The distance between the first further point of intersection and the center of gravity CG and the distance between the second point of intersection and the center of gravity may be the same.

By arranging the first point of intersection and the second point of intersection spaced from the center of gravity CG of the object support 20 on the imaginary axis IA, the first actuator 22 and the second actuator 23 can be used to exert forces, for example a moment, to rotate the object support 20 around a vertical axis (Rz-direction). In order to selectively move the object support 20 with respect to the support part 21 in x-direction and/or Rz direction, the first actuator 22 and the second actuator 23 need to be controlled separately. For example, to actuate the first actuator 22 a first amplifier may be provided and to actuate the second actuator 23 a second amplifier may be provided, wherein the first amplifier and second amplifier may be provided with different control signals.

In an embodiment, the first actuator 22 and the second actuator 23 may be arranged such that the first force direction of the first actuator 22 and the second force direction of the second actuator 23 are directed to the center of gravity CG.

Figure 12 shows a further embodiment of a substrate positioning device 180. In the positioning device 180 of Figure 12, a third actuator 26 and a fourth actuator 27 are provided. The third actuator 26 is arranged in the same x-z plane as the first actuator 22; and, seen in y-direction the third actuator 26 is arranged at the same location (i.e. the same x and z position) and with the same second tilt angle β as the second actuator 23. The fourth actuator 27 is arranged in the same x-z plane as the second actuator 23; and, seen in y-direction, the fourth actuator 27 is arranged at the same location (i.e. the same x and z position) and with the same first tilt angle α as the first actuator 22. In alternative embodiments, the third actuator 26 and the fourth actuator 27 may be arranged at other locations for example not in the same x-z planes as the first actuator 22 and the second actuator 23, respectively.

As can be seen in Figure 12, the force direction of the third actuator 26 may intersect the imaginary axis IA at the first point of intersection, and the force direction of the fourth actuator 27 may intersect the imaginary axis IA at the second point of intersection.

The provision of the third actuator 26 and the fourth actuator 27 provides more versatility to exert actuation forces on the object support 20 to move the object support 20 in the first motion direction, for example without introducing moments about z-axis in the object support 20.

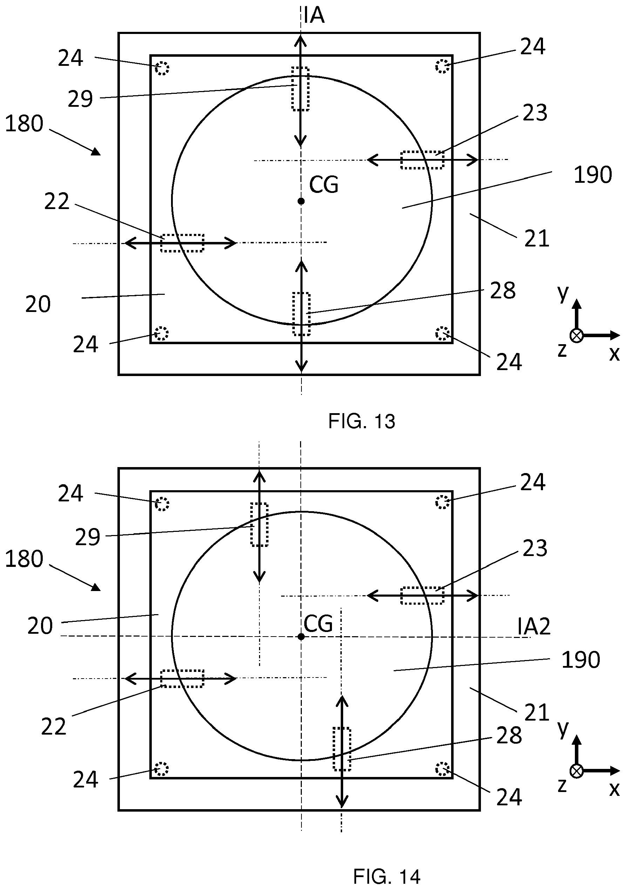

Figure 13 shows another embodiment of a substrate positioning device 180. In comparison with the embodiments of Figures 10 and 11, a first y-actuator 28 and a second y-actuator 29 are provided to exert an actuation force to move the object support 20 in a second motion direction. The second motion direction in this embodiment is the y-direction.

To avoid disturbances of the electron beam of the e-beam apparatus by the magnetic stray fields of the first y-actuator 28 and the second y-actuator 29, the first y-actuator 28 and the second y-actuator 29 are arranged below the magnetic shield 25 (not shown in Figure 13). To reduce the moments about the x-axis in the object support 20, the first y-actuator 28 and the second y-actuator 29 are tilted at a tilt angle, similar to the tilted first actuator 22 and the second actuators 23. The tilt angles of the first y-actuator 28 and the second y-actuator 29 are selected such that the force direction of each of the first y-actuator 28 and the second y-actuator 29 extends in the y-z plane and is pointed at the center of gravity CG. The sum of the tilt angle of the first y-actuator 28 and the tilt angle of the second y-actuator 29 with respect to the positive direction of the y-direction is for example about 0 degrees.

The substrate positioning device 180 of the embodiment of Figure 13 allows to move the object support 20 with respect to the support part 21 in the x-direction by actuation of the first actuator 22 and the second actuator 23 and in the y-direction by actuation of the first y-actuator 28 and the second y-actuator 29. Furthermore, the first actuator 22 and the second actuator 23 can be used to rotate the object support 20 in the Rz. Since the first actuator 22 and the second actuator 23 can be used for Rz-rotation, the force directions of the first y-actuator 28 and the second y-actuator 29 can directly be pointed at the center of gravity CG. In order to selectively move the object support 20 with respect to the support part 21 in x-direction and/or Rz direction, the first actuator 22 and the second actuator 23 of the embodiment of Figure 13 need to be controlled separately.

Figure 14 shows an alternative embodiment of the embodiment of Figure 13. In the embodiment of Figure 14, the force directions of the first y-actuator 28 and the second y-actuator 29 are each pointed at a second imaginary axis IA2 extending in x-direction through the center of gravity CG instead of directly to the center of gravity CG.

A first further point of intersection of the force direction of the first y-actuator 28 and the second imaginary axis IA2 is located on a first second imaginary axis part of the second imaginary axis IA2, the first second imaginary axis part extending from the center of gravity CG in a first second imaginary axis direction, e.g. the positive x-direction, a second further point of intersection of the second force direction of the second y-actuator 29 and the second imaginary axis IA2 is located on a second imaginary axis part of the second imaginary axis, the second imaginary axis part extending from the center of gravity CG in a second imaginary axis direction, e.g. the negative x-direction. The distance between the first further point of intersection and the center of gravity CG and the distance between the second point of intersection and the center of gravity may be the same.

In this embodiment, the first y-actuator 28 and the second y-actuator 29 can also be used for Rz-rotation. In order to selectively move the object support 20 with respect to the support part 21 in x-direction, y-direction and/or Rz direction, the first actuator 22, the second actuator 23, the first y-actuator 28 and the second y-actuator 29 may be controlled separately.

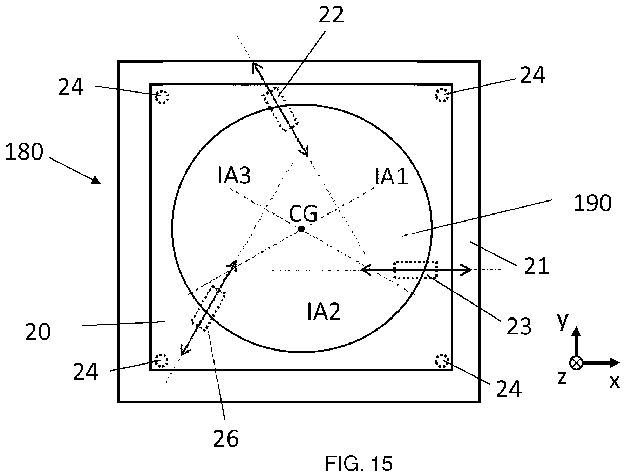

Figure 15 shows another embodiment of a positioning device 180. The positioning device 180 of Figure 15 comprises another actuator configuration comprising a first actuator 22, a second actuator 23 and a third actuator 26 to move the object support 20 with respect to the support part 21 in at least the x-direction, y-direction and Rz-direction. The first actuator 22, the second actuator 23 and the third actuator 26 are arranged in an x-y plane that is spaced in a spacing direction, e.g. z-direction, with respect to the x-y plane in which the center of gravity CG of the object support 20 is arranged,.

The first actuator 22 is arranged to exert a first actuation force between the object support 20 and the support part 21 in a first force direction. The second actuator 23 is arranged to exert a second actuation force between the object support 20 and the support part 21 in a second force direction. And, the third actuator 26 is arranged to exert a third actuation force between the object support 20 and the support part 21 in a third force direction.

Each of the first force direction, second force direction, and third force direction is tilted with respect to the x-y plane in which the actuators 22, 23, 26 are arranged, i.e. each force direction comprises a spacing direction component in the spacing direction. The first force direction is pointed towards a first imaginary axis IA1 running through the center of gravity CG, perpendicular to the first force direction and the spacing direction. Correspondingly, the second force direction is pointed towards a second imaginary axis IA2 running through the center of gravity CG, perpendicular to the second force direction and the spacing direction, and the third force direction is pointed towards a third imaginary axis IA3 running through the center of gravity CG, perpendicular to the third force direction and the spacing direction.

Further, each of the first force direction, second force direction, and third force direction comprises a component in the x-y plane in which the actuators 22, 23, 26 are arranged. The component in the x-y plane of the first actuator 22 is arranged at an angle of - 120 degrees with respect to the x-direction, the component in the x-y plane of the second actuator 23 is arranged at an angle of 0 degrees with respect to the x-direction, and the component in the x-y plane of the third actuator 26 is arranged at an angle of + 120 degrees with respect to the x-direction.

When each of the first actuator 22, the second actuator 23 and the third actuator 26 are controlled separately, for example by three amplifiers that each may be provided with its own control signal, the first actuator 22, the second actuator 23 and the third actuator 26 may be used to selectively move the object support 20 in at least the x-direction, y-direction and/or Rz-direction with respect to the support part 21.

In an embodiment, the actuators 22, 23, 26 may be arranged such that the first force direction of the first actuator 22, the second force direction of the second actuator 23and the third force direction of the third actuator 26 are directed to the center of gravity CG.

The embodiments of the substrate positioning device 180 of Figures 9 to 15 are arranged to move a substrate 190 in at least a first motion direction. The substrate positioning device may for example be applied in a particle beam apparatus, an electron beam apparatus, an electron beam inspection apparatus, a lithographic apparatus, or a metrology apparatus.

Further embodiments may be described in the following clauses:
1. An object positioning device, comprising:
   an object support configured to support an object,
   a support part configured to movably support the object support, and
   at least one actuator system configured to actuate movement of the object support relative to the support part in a motion direction,
   wherein the at least one actuator system comprises:
   an actuator configured to apply an actuation force to the object support in a force direction wherein the force direction having a first component in the motion direction and a second component in a direction substantially perpendicular to the motion direction.
2. The object positioning device according to clause 1, wherein the object support having a center of gravity, wherein the actuator is spaced at least in a spacing direction with respect to the center of gravity, the spacing direction being substantially perpendicular to the motion direction, and wherein the direction substantially perpendicular to the motion direction is the spacing direction.
3. The object positioning device according to clause 2 , wherein the object support comprises an imaginary axis through the center of gravity and substantially perpendicular to the motion direction and the spacing direction, wherein the actuator is arranged such that the force direction is substantially pointing towards the imaginary axis.
4. The object positioning device according to clause 3, wherein the force direction is substantially perpendicular to the imaginary axis.
5. The object positioning device according to any of the clauses 2 to 4, wherein the force direction is substantially pointing towards the center of gravity.
6. The object positioning device according to any of the clauses 2 to 5, wherein the motion direction is a horizontal direction and wherein the spacing direction is a vertical direction.
7. The object positioning device according to any of the clauses 2 to 6, wherein the at least one actuator system comprises:
   a second actuator configured to apply an actuation force to the object support in a second force direction, wherein the second actuator is spaced at least in the spacing direction with respect to the center of gravity, the second force direction having a first component in the spacing direction and a second component in the motion direction.
8. The object positioning device according to clause 7, wherein the object support comprises an imaginary axis through the center of gravity and substantially perpendicular to the motion direction and the spacing direction, wherein the actuator is arranged such that the force direction is substantially pointing towards a first imaginary axis part of the imaginary axis, the first imaginary axis part extending from the center of gravity in a first imaginary axis direction, and wherein the second actuator is arranged such that the second force direction is substantially pointing towards a second imaginary axis part of the imaginary axis, the second imaginary axis part extending from the center of gravity in a second imaginary axis direction, opposite to the first imaginary axis direction.
9. The object positioning device according to clause 7 or 8, wherein a sum of a first tilt angle of the force direction of the actuator and a second tilt angle of the second force direction of the second actuator with respect to a positive direction of the motion direction is about 0 degrees.
10. The object positioning device according to any of the clauses 2 to 9 , wherein the object positioning device comprises a further actuator system configured to actuate movement of the object support relative to the support part in a second motion direction, wherein the second motion direction is substantially perpendicular to the motion direction and the spacing direction, and
   wherein the further actuator system comprises a further actuator configured to apply an actuation force to the object support in a further force direction, wherein the further actuator is spaced at least in the spacing direction with respect to the center of gravity, the further force direction having a first component in the spacing direction and a second component in the second motion direction.
11. The object positioning device according to any preceding clauses, wherein the object is a substrate, a wafer, or a patterning device.
12. The object positioning device according to any preceding clauses, wherein the support part is movably supported on a base, wherein a second actuator system is provided to move the support part with respect to the base.
13. The object positioning device according to clause 12, wherein the at least one actuator system is arranged to move the object support with respect to the support part over a first range of movement, wherein the second actuator system is arranged to move the support part with respect to the base over a second range of movement, wherein the second range of movement is substantially larger than the first range of movement.
14. The object positioning device according to any of clause 2 to 13, wherein the object positioning device comprises a magnetic shield arranged between the center of gravity and the actuator.
15. An apparatus comprising the object positioning device according to any preceding clauses, wherein the apparatus is a particle beam apparatus, an electron beam apparatus, an electron beam inspection apparatus, a lithographic apparatus, or a metrology apparatus.

A corresponding object positioning device may also be applied to position other objects, such as a patterning device, also referred to as mask or reticle, that have to be positioned with high accuracy.

Although the present invention has been explained in relation to its preferred embodiment, it is to be understood that other modifications and variation can be made without departing the spirit and scope of the invention as hereafter claimed.

## Claims

1. An object positioning device, comprising:
an object support configured to support an object,
a support part configured to movably support the object support, and
at least one actuator system configured to actuate movement of the object support relative to the support part in a motion direction,
wherein the at least one actuator system comprises:
an actuator configured to apply an actuation force to the object support in a force direction wherein the force direction having a first component in the motion direction and a second component in a direction substantially perpendicular to the motion direction.

2. The object positioning device according to claim 1, wherein the object support having a center of gravity, wherein the actuator is spaced at least in a spacing direction with respect to the center of gravity, the spacing direction being substantially perpendicular to the motion direction, and wherein the direction substantially perpendicular to the motion direction is the spacing direction.

3. The object positioning device according to claim 2, wherein the object support comprises an imaginary axis through the center of gravity and substantially perpendicular to the motion direction and the spacing direction, wherein the actuator is arranged such that the force direction is substantially pointing towards the imaginary axis.

4. The object positioning device according to claim 3, wherein the force direction is substantially perpendicular to the imaginary axis.

5. The object positioning device according to claim 2, wherein the force direction is substantially pointing towards the center of gravity.

6. The object positioning device according to claim 2, wherein the motion direction is a horizontal direction and wherein the spacing direction is a vertical direction.

7. The object positioning device according to claim 2, wherein the at least one actuator system comprises:
a second actuator configured to apply an actuation force to the object support in a second force direction, wherein the second actuator is spaced at least in the spacing direction with respect to the center of gravity, the second force direction having a first component in the spacing direction and a second component in the motion direction.

8. The object positioning device according to claim 7, wherein the object support comprises an imaginary axis through the center of gravity and substantially perpendicular to the motion direction and the spacing direction, wherein the actuator is arranged such that the force direction is substantially pointing towards a first imaginary axis part of the imaginary axis, the first imaginary axis part extending from the center of gravity in a first imaginary axis direction, and wherein the second actuator is arranged such that the second force direction is substantially pointing towards a second imaginary axis part of the imaginary axis, the second imaginary axis part extending from the center of gravity in a second imaginary axis direction, opposite to the first imaginary axis direction.

9. The object positioning device according to claim 7, wherein a sum of a first tilt angle of the force direction of the actuator and a second tilt angle of the second force direction of the second actuator with respect to a positive direction of the motion direction is about 0 degrees.

10. The object positioning device according to claim 2, wherein the object positioning device comprises a further actuator system configured to actuate movement of the object support relative to the support part in a second motion direction, wherein the second motion direction is substantially perpendicular to the motion direction and the spacing direction, and
wherein the further actuator system comprises a further actuator configured to apply an actuation force to the object support in a further force direction, wherein the further actuator is spaced at least in the spacing direction with respect to the center of gravity, the further force direction having a first component in the spacing direction and a second component in the second motion direction.

11. The object positioning device according to claim 1, wherein the object is a substrate, a wafer, or a patterning device.

12. The object positioning device according to claim 1, wherein the support part is movably supported on a base, wherein a second actuator system is provided to move the support part with respect to the base.

13. The object positioning device according to claim 12, wherein the at least one actuator system is arranged to move the object support with respect to the support part over a first range of movement, wherein the second actuator system is arranged to move the support part with respect to the base over a second range of movement, wherein the second range of movement is substantially larger than the first range of movement.

14. The object positioning device according to claim 2, wherein the object positioning device comprises a magnetic shield arranged between the center of gravity and the actuator.

15. An apparatus comprising the object positioning device according to claim 1, wherein the apparatus is a particle beam apparatus, an electron beam apparatus, an electron beam inspection apparatus, a lithographic apparatus, or a metrology apparatus.
